# EUROPEAN PATENT APPLICATION

(11) **EP 4 614 792 A1**
(43) Date of publication of application: **10.09.2025**
(21) Application number: 23885454.1
(22) Date of filing: 05.10.2023
(51) Int. Cl.: H02M 7/48, H02K 11/33

(54) **INTEGRATED MODULE**

(30) Priority: 31.10.2022 JP 2022174330
(71) Applicant: AISIN CORPORATION, Kariya-shi, Aichi 448-8650 (JP)
(72) Inventor: YAMAMOTO, Takeru, Kariya-shi, Aichi 448-8650 (JP); YAMADA, Yasutoshi, Kariya-shi, Aichi 448-8650 (JP); ISHII, Masato, Kariya-shi, Aichi 448-8650 (JP); YAMAGUCHI, Tomohiro, Kariya-shi, Aichi 448-8650 (JP); SASAKI, Sozaburo, Kariya-shi, Aichi 448-8650 (JP)
(74) Representative: Winter, Brandl - Partnerschaft mbB
(86) International application number: PCT/JP2023/036354
(87) International publication number: WO 2024/095691

(57) **Abstract**

An aggregation module includes a plurality of drivers that energize each of a plurality of auxiliary machines mounted on a vehicle, a common substrate equipped with a plurality of the drivers, and a module housing that holds the substrate.

## Description

### TECHNICAL FIELD

The present invention relates to an aggregation module including drivers that energize auxiliary machines mounted on a vehicle.

### BACKGROUND ART

Conventionally, various auxiliary machines (an electric pump, a valve device, and the like, for example) are mounted on the vehicle. Such auxiliary machines are energized by a driver. As a technique related to such a driver, for example, there is a technique described in Patent Literature 1 of which source is described below.

Patent Literature 1 describes an inverter device. The inverter device includes a power module including a switching element, a cooling module that cools the power module, a control board including a control circuit that controls the switching element, an AC busbar connected to an AC terminal of the power module, and a current sensor that detects current flowing through the AC busbar.

### CITATIONS LIST

### PATENT LITERATURE

Patent Literature 1: JP 2017-153228 A

### SUMMARY OF INVENTION

### TECHNICAL PROBLEMS

The inverter device described in Patent Literature 1 is downsized by providing on one side of the cooling module the control board equipped with a power module, and by providing the AC busbar and a current sensor on another side of the cooling module. However, as described above, the vehicle includes various auxiliary machines, and if the inverter device is provided for each auxiliary machine, the inverter device is inevitably large in size. For this reason, there is room for improvement in downsizing, in view of correspondence to a plurality of auxiliary machines.

Therefore, an aggregation module capable of being downsized is required.

### SOLUTIONS TO PROBLEMS

A characteristic configuration of an aggregation module according to the present invention is that the aggregation module includes a plurality of drivers that energize each of a plurality of auxiliary machines mounted on a vehicle, a common substrate equipped with a plurality of the drivers, and a module housing that holds the substrate.

With such a characteristic configuration, the plurality of drivers can be collectively mounted on the common substrate, and thus, for example, downsizing is possible as compared with a case where the plurality of drivers are mounted on separate substrates. Therefore, the aggregation module can be reduced in weight. Furthermore, in a case where mounting on a vehicle is considered, flexibility in mounting can be increased, because downsizing is achieved.

Furthermore, another characteristic configuration of the aggregation module according to the present invention is that the aggregation module includes a plurality of drivers that energize each of a plurality of auxiliary machines mounted on a vehicle, a common substrate equipped with a plurality of the drivers, and a module housing that holds the substrate, the aggregation module distributing a coolant to a plurality of apparatuses mounted on the vehicle.

With such a characteristic configuration, as described above, the aggregation module can be downsized, and the coolant can be distributed to the plurality of apparatuses mounted on the vehicle, and thus the apparatuses can be appropriately cooled.

### BRIEF DESCRIPTION OF DRAWINGS

FIG. 1 is a side-sectional view of a cooling module.
FIG. 2 is a top view of a substrate.
FIG. 3 is a diagram showing a vehicle cooling circuit.

### DESCRIPTION OF EMBODIMENTS

An aggregation module according to the present invention is configured such that a plurality of drivers can be mounted on a substrate. Hereinafter, an aggregation module 1 of the present embodiment will be described.

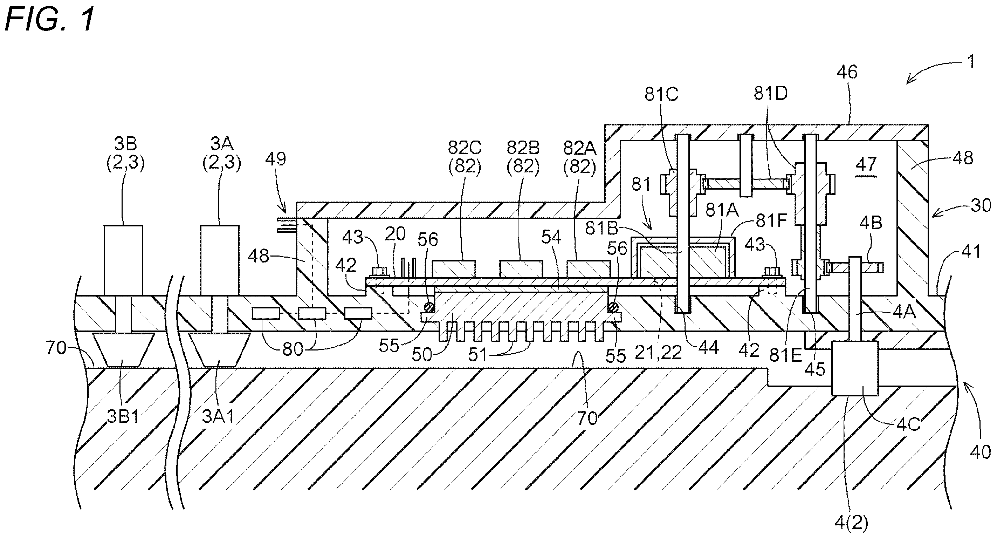

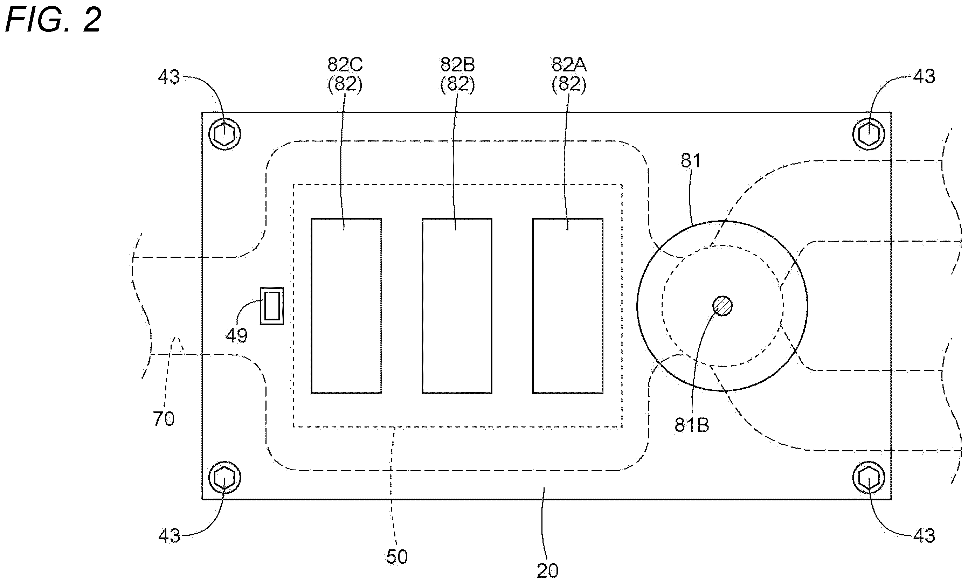

FIG. 1 is a side-sectional view of the aggregation module 1. As shown in FIG. 1, the aggregation module 1 includes drivers 82, a substrate 20, and a module housing 30. FIG. 2 shows a top view of the substrate 20.

A plurality of drivers 82 are provided, and energize each of a plurality of auxiliary machines 2 mounted on a vehicle. The plurality of auxiliary machines 2 mounted on the vehicle are a plurality of apparatuses that assist driving of a power source (an engine or a rotating electrical machine, for example) that moves (drives) a vehicle including the aggregation module 1. Examples of such auxiliary machines 2 include an electric generator, a radiator, an oil pump, a water pump, motors for driving these pumps, a valve device, and the like. Such a plurality of auxiliary machines 2 are mounted on the vehicle, but in the present embodiment, a motor 81 water pumps 3 (an example of a "pump"), and a valve device 4 are included as the plurality of auxiliary machines 2. Although details will be described later, in the present embodiment, the motor 81 drives the valve device 4. The motor 81, the water pump 3, and the valve device 4 will be described later.

The drivers 82 energize the motor 81 and the water pump 3. As with an H-bridge, a three-phase inverter, or the like, the drivers 82 can include, for example, a plurality of arm portions having a high-side switching element and a low-side switching element that are formed by being connected to each other in series.

An operation command is transmitted from a control unit (not shown) to each of the drivers 82. The operation command includes, for example, a command value of rotational speed, an output torque or the like, and the drivers 82 are controlled on the basis of such a command value. As a result, current having a current value corresponding to the command value flows from the drivers 82 to a coil of the motor 81 that drives the valve device 4 or coils of motors (not shown) included in the water pump 3.

A plurality of drivers 82 are mounted on the substrate 20. In the present embodiment, the plurality of drivers 82 are mounted on a common substrate 20. That is, the plurality of drivers 82 are mounted on a single substrate 20. FIG. 1 shows, as the drivers 82, a driver 82A that energizes the motor 81, a driver 82B that energizes the motor of the water pump 3A, and a driver 82C that energizes the motor of the water pump 3B.

In the present embodiment, the substrate 20 is equipped with the motor 81, the driver 82A, the driver 82B, and the driver 82C. The driver 82A, the driver 82B, and the driver 82C include switching elements, and terminals of the switching elements can be fixed by solder welding to lands provided on the substrate 20. Of course, the terminals of the switching elements can be inserted into and fixed to through holes provided in the substrate 20.

Furthermore, the substrate 20 may be equipped with a control unit (not shown) that controls at least one of the plurality of drivers 82. In a case where the motor 81 and the water pump 3 are driven by PWM control, the control unit that controls at least one of the plurality of drivers 82 corresponds to, for example, a PWM control unit. The control unit is not limited to the PWM control unit, and may be, for example, a power feed control unit that is provided at an input stage of the drivers 82 and is able to shut off power supplied to the drivers 82.

Such a substrate 20 includes a rigid substrate from a viewpoint of heat dissipation and load bearing. In particular, the substrate 20 can be implemented at low cost by using a printed circuit board.

The module housing 30 holds the substrate 20. The module housing 30 is made of, for example, resin. The module housing 30 has a channel housing 40 to be described later. In the present embodiment, the substrate 20 is held on an outer surface 41 of the channel housing 40. A projection 42 protruding from the outer surface 41 of the channel housing 40 is provided on the outer surface 41, and the substrate 20 is fastened and fixed with bolts 43, in a state of being placed on the projection 42.

Moreover, a plurality of wall portions 48 erected from the outer surface 41 are formed in the channel housing 40, and a top plate 46 is supported over the plurality of wall portions 48. As a result, the substrate 20 is housed in a space 47 surrounded by the channel housing 40, the wall portions 48, and the top plate 46. Furthermore, busbars 80 are insert-molded in the channel housing 40, and power is supplied from busbars 80 to a predetermined land of the substrate 20 via press-fitting. In the example in FIG. 1, a wiring line electrically connected to the busbars 80 is provided inside the wall portions 48, and a connector part 49 is formed so as to protrude to a side opposite to the space 47 in the wall portions 48. This makes it possible to extract power from the busbars 80 via the connector part 49.

The motor 81 drives the valve device 4. In the present embodiment, a gear 81C is provided at one end of a rotary shaft 81B of a rotor 81A of the motor 81. A gear (an example of a "transmission") 81D that reduces rotational speed of the motor 81 is provided so as to mesh with the gear 81C, and the gear 81D and a gear 4B provided on a rotary shaft 4A of the valve device 4 so as to mesh with each other. This makes it possible for the motor 81 to drive the valve device 4.

Furthermore, the motor 81 is provided such that another end of the rotary shaft 81B penetrates the substrate 20, and the motor 81 is supported by the substrate 20 through a motor housing 81F. The motor housing 81F and the substrate 20 may be fastened and fixed by using, for example, a bolt, or may be fixed by another method. Furthermore, the motor 81 and the substrate 20 can be electrically connected by inserting a press-fit 22 into a through hole 21 provided in the substrate 20.

Furthermore, although the gear 81C is provided at one end of the rotary shaft 81B of the motor 81 as described above, another end of the rotary shaft 81B is supported with bearing, in a state of being inserted into a recess 44 formed in the outer surface 41. Moreover, in the present embodiment, a rotary shaft 81E of the gear 81D is also supported with bearing, in a state of being inserted into a recess 45 formed in the outer surface 41. Therefore, the motor 81 and the gear 81D are held by the module housing 30.

Each of the water pumps 3 cause a coolant to flow through a cooling channel 70. For example, the cooling channel 70 communicates with a device other than a power source such as an engine or a rotating electrical machine and a power source such as an electric generator or a battery, and the coolant discharged from the water pump 3 is supplied through the cooling channel 70. The coolant is cooling water such as a long-life coolant (LLC), an insulating oil such as paraffin, or a refrigerant condensate such as hydrofluorocarbon (HFC) or hydrofluoroolefin (HFO). This makes it possible to cool a supply destination (the engine, the rotating electrical machine, the electric generator, the battery, or the like) of the coolant. In the present embodiment, two water pumps 3 are provided as shown in FIG. 1, and in a case where the water pumps 3 are distinguished from each other, one water pump 3 will be described as a water pump 3A, and another water pump 3 will be described as a water pump 3B.

The valve device 4 is configured to be able to adjust, on the basis of output from the motor 81, an amount of the coolant flowing through the cooling channel 70, or switching channels. As shown in FIG. 1, the valve device 4 is provided on the cooling channel 70. The valve device 4 may be provided to adjust the coolant sucked into the water pump 3 or switch channels, or may be provided to adjust an amount of the coolant discharged from the water pump 3 or switch the channels. In the present embodiment, the valve device 4 is provided on the cooling channel 70 on which the water pump 3A is provided.

In the present embodiment, the module housing 30 holds the water pump 3A, the water pump 3B, and the valve device 4, in addition to the substrate 20. In the present embodiment, the water pump 3A and the water pump 3B are provided such that a vane part 3A1 and a vane part 3B1 are positioned on a cooling channel 70 side in the module housing 30, and that the valve device 4 is provided such that a valve part 4C is positioned on a cooling channel 70 side in the module housing 30.

The cooling channel 70 described above is formed inside the channel housing 40, and the coolant flows through the cooling channel 70. The channel housing 40 is made of resin, and the cooling channel 70 can be formed, for example, on a split surface by drilling.

A heat sink 50 is provided over the substrate 20 and the cooling channel 70. **In** the present embodiment, one side of the heat sink 50 is attached to the substrate 20 via a gap filler 54, and another side of the heat sink 50 is provided in a state of being exposed to the cooling channel 70. As shown in FIG. 2, the heat sink 50 is preferably attached to, for example, a back side of an area on the substrate 20, on which the drivers 82 are mounted. Furthermore, at least at a portion where the cooling channel 50 overlaps the heat sink, the cooling channel 70 is preferably wider outward than the heat sink 50 when the substrate 20 is viewed from above. That is, the cooling channel 70 is preferably configured such that the heat sink 50 overlaps the cooling channel 70 when the substrate 20 is viewed from above. As a result, heat from the drivers 82 can be easily transferred to the heat sink 50. Note that a flange portion 55 of the heat sink 50 is preferably provided with a seal member 56 (for example, an O-ring).

In the present embodiment, the heat sink 50 is provided in the channel housing 40 and includes fins 51 erected toward an inside of the cooling channel 70. As a result, the heat sink 50 to which the heat from the drivers 82 is transferred can be directly cooled by the coolant flowing through the cooling channel 70. Therefore, the drivers 82 can be cooled more efficiently. The heat sink 50 may be configured such that the fins 51 are erected in a state of intersecting (preferably being orthogonal to) a direction in which the coolant flows through the cooling channel 70, or may be configured such that the fins 51 are erected in a state of being parallel to the direction in which the coolant flows through the cooling channel 70. Furthermore, the heat sink 50 can include a plurality of plate-like members and pins instead of the fins 51.

As described above, by configuring the substrate 20, which is equipped with the plurality of drivers 82, to be held by the module housing 30, it is possible to configure the aggregation module 1 including the plurality of drivers 82 in an aggregated manner. With such an aggregation module 1, downsizing is possible even in a case where the plurality of drivers 82 are provided on the substrate 20. Furthermore, the plurality of drivers 82 can be appropriately cooled.

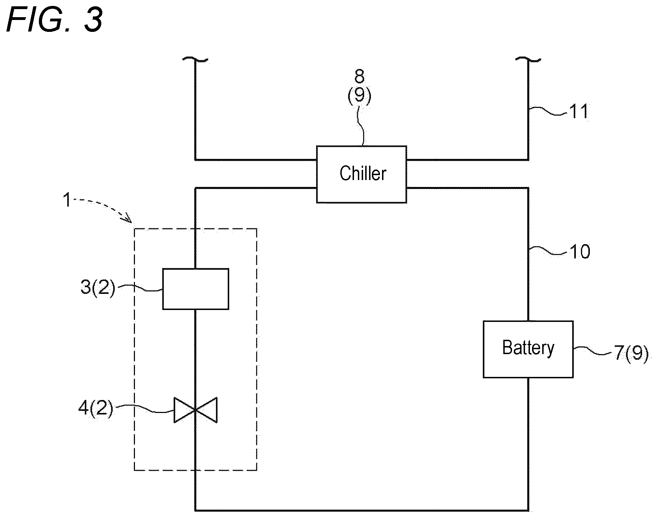

Furthermore, according to the aggregation module 1 described above, the coolant can be distributed to a plurality of apparatuses 9 mounted on the vehicle. The apparatuses 9 are a supply destination of the coolant described above, and correspond to an engine, a rotating electrical machine, an electric generator, a battery, and the like. FIG. 3 shows a circuit diagram in a case where a coolant is distributed to a battery 7 and a chiller 8 by the aggregation module 1. The chiller 8 is also included in the apparatuses 9.

As shown in FIG. 3, the water pump 3 energized by the drivers 82 of the aggregation module 1 and the valve device 4 driven by the motor 81 energized by the drivers 82 constitute a coolant circuit 10 through which the coolant flows to the battery 7 and the chiller 8. As a result, the coolant flows through the battery 7 and the chiller 8 via the water pump 3 and the valve device 4. Furthermore, a refrigerant flows through the chiller 8 by a refrigerant circuit 11, and heat is exchanged between the refrigerant and the coolant in the chiller 8. In this manner, the aggregation module 1 can be achieved as a cooling aggregation module.

### [Other embodiments]

Next, other embodiments of an aggregation module 1 will be described.

In the above embodiment, it has been described that the module housing 30 holds the motor 81, the gear 81D, the valve device 4, and the water pump 3. However, the module housing 30 may hold at least one of the motor 81, the gear 81D, the valve device 4, and the water pump 3. Furthermore, the module housing 30 may not hold the motor 81, the gear 81D, the valve device 4, and the water pump 3.

Furthermore, for example, the module housing 30 may be configured to hold a sensor used for controlling the auxiliary machines 2. As a result, the aggregation module 1 can be further downsized.

In the above embodiment, it has been described that the substrate 20 is equipped with the control unit that controls at least one of the plurality of drivers 82. However, the substrate 20 may not be equipped with the control unit.

In the above embodiment, it has been described that the substrate 20 is supported by the outer surface 41 of the channel housing 40. However, the substrate 20 may be supported at a portion different from the outer surface 41 of the channel housing 40, or may be supported in a state of being separated from the outer surface 41, for example.

### [Overview of above embodiments]

Hereinafter, an overview of the aggregation module 1 described above will be described.
(1) An aggregation module 1 includes a plurality of drivers 82 that energize each of a plurality of auxiliary machines 2 mounted on a vehicle, a common substrate 20 equipped with the plurality of drivers 82, and a module housing 30 that holds the substrate 20.
   According to this configuration, the plurality of drivers 82 can be collectively mounted on the common substrate 20, and thus, for example, downsizing is possible as compared with a case where the plurality of drivers 82 are mounted on separate substrates. Therefore, the aggregation module 1 can be reduced in weight. Furthermore, in a case where mounting on a vehicle is considered, flexibility in mounting can be increased, because downsizing is achieved.
(2) An aggregation module 1 includes a plurality of drivers 82 that energize each of a plurality of auxiliary machines 2 mounted on a vehicle, a common substrate 20 equipped with the plurality of drivers 82, and a module housing 30 that holds the substrate 20, the aggregation module housing 30 distributing a coolant to a plurality of apparatuses 9 mounted on the vehicle.
   According to this configuration, as described above, the aggregation module 1 can be downsized, and the coolant can be distributed to the plurality of apparatuses 9 mounted on the vehicle, and thus the apparatuses 9 can be appropriately cooled.
(3) In the aggregation module 1 according to (1) or (2), the plurality of auxiliary machines 2 preferably include a motor 81, and the module housing 30 further holds the motor 81.
   According to this configuration, the substrate 20 and the motor 81 are held by a common module housing 30, and thus downsizing is possible. Furthermore, because the drivers 82 and motor 81 mounted on the substrate 20 can be provided close to each other, routing of wiring can be simplified. Furthermore, because a wiring length can be shortened, power loss can be reduced.
(4) In the aggregation module 1 according to (3), the module housing 30 preferably further holds a gear (transmission) 81D that reduces rotational speed of the motor 81.
   According to this configuration, the substrate 20, the motor 81, and the gear 81D are held by the common module housing 30, and thus downsizing is possible. Furthermore, the motor 81 and the gear 81D can be provided close to each other, and thus, a smaller size of the gear 81D can be used.
(5) In the aggregation module 1 according to (3) or (4), the plurality of auxiliary machines 2 preferably include a valve device 4 that adjusts, on the basis of output from the motor 81, an amount of fluid flowing through a cooling channel 70, or switch cooling channels (channels) 70, and the module housing 30 further holds the valve device 4.
   According to this configuration, the substrate 20, the motor 81, and the valve device 4 are held by the common module housing 30, and thus downsizing is possible.
(6) In the aggregation module 1 according to (1) or (2), the plurality of auxiliary machines 2 preferably further include water pump 3 that causes fluid to flow through a cooling channel 70, and the module housing 30 preferably further holds the water pump 3.
   According to this configuration, the substrate 20 and the water pump 3 are held by the common module housing 30, and thus downsizing is possible. Furthermore, because the drivers 82 mounted on the substrate 20 and the water pump 3 can be provided close to each other, routing of wiring can be simplified. Furthermore, because a wiring length can be shortened, power loss can be reduced.
(7) In the aggregation module 1 according to (1) or (2), the module housing 30 preferably further holds a sensor used for controlling the auxiliary machines 2.

According to this configuration, the substrate 20 and a sensor are held by the common module housing 30, and thus downsizing is possible. Furthermore, because the drivers 82 mounted on the substrate 20 and the sensor can be provided close to each other, routing of wiring can be simplified.

### INDUSTRIAL APPLICABILITY

The present invention can be used for an aggregation module that cools drivers that energize auxiliary machines mounted on a vehicle.

### REFERENCE SIGNS LIST

1: Aggregation module, 2: Auxiliary machine, 3: Water pump (pump), 4: Valve device, 9: Apparatus, 20: Substrate, 30: Module housing, 70: Cooling channel (channel), 81: Motor, 81D: Gear (transmission), and 82: Driver

## Claims

1. An aggregation module comprising:
a plurality of drivers that energize each of a plurality of auxiliary machines mounted on a vehicle;
a common substrate equipped with a plurality of the drivers; and
a module housing that holds the substrate.

2. A cooling aggregation module comprising:
a plurality of drivers that energize each of a plurality of auxiliary machines mounted on a vehicle;
a common substrate equipped with a plurality of the drivers; and
a module housing that holds the substrate,
the aggregation module distributing a coolant to a plurality of apparatuses mounted on the vehicle.

3. The aggregation module according to claim 1 or 2, wherein
a plurality of the auxiliary machines include a motor, and
the module housing further holds the motor.

4. The aggregation module according to claim 3, wherein
the module housing further holds a transmission that reduces rotational speed of the motor.

5. The aggregation module according to claim 3 or 4, wherein
a plurality of the auxiliary machines include a valve device that adjusts, on the basis of output from the motor, an amount of fluid flowing through a channel, or switch channels, and
the module housing further holds the valve device.

6. The aggregation module according to claim 1 or 2, wherein
a plurality of the auxiliary machines further include a pump that causes fluid to flow through a channel, and
the module housing further holds the pump.

7. The aggregation module according to claim 1 or 2, wherein the module housing further holds a sensor used for controlling the auxiliary machines.
